**Europäisches Patentamt**

**European Patent Office**

**Office européen des brevets**

(19)

(11) Veröffentlichungsnummer: **0 065 132**
A1

(12) **EUROPÄISCHE PATENTANMELDUNG**

(21) Anmeldenummer: **82103522.7**

(22) Anmeldetag: **26.04.82**

(51) Int. Cl.³: **G 01 R 11/56,** G 01 R 21/00, G 01 F 15/075

(30) Priorität: **11.05.81 DE 3118624**

(43) Veröffentlichungstag der Anmeldung: **24.11.82** **Patentblatt 82/47**

(84) Benannte Vertragsstaaten: **AT BE CH DE FR GB IT LI NL SE**

(71) Anmelder: **SIEMENS AKTIENGESELLSCHAFT Berlin und München, Postfach 22 02 61, D-8000 München 22 (DE)**

(72) Erfinder: **Steinmüller, Günter, Laufamholzstrasse 65, D-8500 Nürnberg (DE)**
Erfinder: **Vieweg, Gunther, Dipl.-Phys., Kesslerplatz 13 a, D-8500 Nürnberg (DE)**

(54) **Tarifgerät zur Bemessung des einem Abnehmer eines Fluids oder von Energie, insbesondere elektrischer Energie, zuzuordnenden Tarifs.**

(57) Bei der Rechnungsstellung für private Verbraucher von Energie, insbesondere elektrischer Energie, soll über die Tarifgestaltung auf den Verbraucher ein Anreiz ausgeübt werden, Verbraucherspitzen zu vermeiden und stattdessen die Energie möglichst gleichmäßig zu entnehmen. Der bei Großabnehmern übliche Maximumtarif ist für Kleinverbraucher jedoch zu kostenungünstig. Aus diesem Grund wird erfindungsgemäß ein Tarifgerät (1) vorgeschlagen, dem eingangsseitig eine Impulsfolge (I) mit leistungsproportionaler Frequenz zugeführt ist. Das Tarifgerät (1) weist einen Impulszähler (3) für die Impulse der Impulsfolge (I) auf, sowie einen Meßperiodengeber (4), der jeweils am Ende einer Meßperiode den Impulszähler (3) zurücksetzt. Der Impulszähler (3) speist einen Potenzwertbildner (6) der ausgangsseitig die n-te Potenz der während einer Meßperiode im Impulszähler (3) eingegangenen Impulszahl liefert, wobei n > 1 ist. Diese n-te Potenz der Impulszahl wird jeweils am Ende jeder Meßperiode dem bisher in einem kumulierenden Zählwerk (7) aufgelaufenen Wert additiv hinzugefügt. Der dem kumulierenden Zählwerk am Ende einer Meßperiode entnehmbare Wert hängt nicht nur von der Menge der entnommenen Energie, sondern auch von der Ungleichmäßigkeit der Entnahme ab und stellt somit ein vernünftiges Maß für eine Tarifgestaltung dar.

SIEMENS AKTIENGESELLSCHAFT    Unser Zeichen    0065132
Berlin und München               VPA  81 P 4 0 3 1 E

Tarifgerät zur Bemessung des einem Abnehmer eines Fluids oder von Energie, insbesondere elektrischer Energie, zuzuordnenden Tarifs

Die Erfindung betrifft ein Tarifgerät zur Bemessung des einem Abnehmer eines Fluids oder von Energie, insbesondere elektrischer Energie, zuzuordnenden Tarifs, dem eingangsseitig eine Impulsfolge mit strömungsgeschwindigkeits- bzw. leistungsproportionaler Frequenz zugeführt wird, mit mindestens einem Impulszähler für die Impulse der Impulsfolge, mit einem Meßperiodengeber, der jeweils am Ende einer Meßperiode den Impulszähler zurücksetzt, sowie mit einem Speicher mit Anzeigevorrichtung für die tarifbestimmende Größe.

Der durch die Elektrizitätsversorgungsunternehmen privaten Abnehmern, insbesondere Haushaltungen, in Rechnung gestellte Abrechnungsbetrag für den Verbrauch elektrischer Energie setzt sich üblicherweise aus zwei Anteilen zusammen, nämlich

1. einem Betrag, der der verbrauchten Energie proportional ist und

2. einer Grundgebühr, die sich im wesentlichen nach der Zahl der dem Verbraucher zur Verfügung stehenden Räume bemißt.

Mit der Grundgebühr sollen im wesentlichen die Kosten für die Verteilung und Bereitstellung der elektrischen Energie abgedeckt werden. Diese Orientierung eines Kostenanteils an der Zimmerzahl stellt eine unbefriedigende Bemessungsgrundlage dar, da die Zimmerzahl kein vernünftiges Maß für die vom Abnehmer angeforderte elektrische Energie darstellt. Es besteht daher das Bedürfnis, meßbare tarifbestimmende Größen zu ermitteln, die

Spl 2 Ste / 05.05.1981

eine vernünftige Aussage über die Inanspruchnahme der
elektrischen Energie gestatten.

Dieses Problem kann in gleicher Weise beim Verbrauch von
Fluiden, beispielsweise von Wasser, oder von anderen
Energieformen, beispielsweise Wärme, auftreten.

Für Großabnehmer hat sich seit vielen Jahren der Maximumtarif durchgesetzt. Hier wird neben dem Verbrauch in kWh
noch der in aufeinanderfolgenden Meßperioden von konstanter Dauer, beispielsweise jeweils einer Viertelstunde,
aufgetretene Verbrauch erfaßt und der während irgendeiner solchen Meßperiode aufgetretene Höchstverbrauch
während einer viele Meßperioden umfassenden Ableseperiode
ermittelt. Der Abnehmer zahlt für jede verbrauchte kWh
einen bestimmten Betrag, die Arbeitsgebühr, die den beweglichen Kosten entspricht, und außerdem eine den festen
Kosten entsprechende Leistungsgebühr, die von dem während
einer Meßperiode des Ablesezeitraums aufgetretenen Maximalverbrauch abhängt. Diese Verrechnungsart paßt sich den
Gestehungskosten am besten an und weckt beim Abnehmer
aus Kostengründen das Interesse an einer möglichst gleichmäßigen Entnahme elektrischer Energie.

Als Tarifgerät für den Maximumtarif sind sogenannte
Maximumzähler bekannt, denen eingangsseitig eine Impulsfolge mit leistungsproportionaler Frequenz zugeführt
werden. Während der durch einen Meßperiodengeber vorgegebenen Meßperiode werden die Impulse der Impulsfolge
in einen Impulszähler eingezählt und mit der während
einer vorangegangenen Meßperiode angefallenen bisherigen
maximalen Impulszahl verglichen. Bei diesem Vergleich
wird die jeweils höhere Impulszahl einem Speicher zugeführt. Anschließend wird der Impulszähler für eine neue
Meßperiode durch den Meßperiodengeber auf Null zurückgestellt. Am Ende der Ableseperiode steht in dem Speicher,
der mit einer Anzeigevorrichtung versehen ist, als tarifbestimmende Größe der innerhalb eines Ablesezeitraums aufgetretene Maximalwert des Energieverbrauchs während einer Meßperiode.

Der Maximumtarif stellt jedoch für private Abnehmer, die ja gegenüber einem Großabnehmer nur über vergleichsweise schlechte Steuerungsmöglichkeiten zur Vergleichmäßigung des elektrischen Energieverbrauches verfügen, einen zu teueren Tarif dar. Darüber hinaus sind Maximumzähler relativ teuere Tarifgeräte.

Der Erfindung liegt die Aufgabe zugrunde, ein Tarifgerät der eingangs genannten Art anzugeben, das kostengünstig herstellbar ist und anstelle der bisherigen Grundgebühr eine den Gegebenheiten und der zumutbaren Kostenbelastung privater Verbraucher Rechnung tragende Quantifizierung einer tarifbestimmenden Größe ermöglicht.

Die Aufgabe wird erfindungsgemäß dadurch gelöst, daß der Impulszähler mit einem Potenzwertbildner verbunden ist, der ausgangsseitig die n-te Potenz der während einer Meßperiode im Impulszähler eingegangenen Impulszahl liefert, wobei n größer als 1 ist und daß diese n-te Potenz der Impulszahl jeweils am Ende jeder Meßperiode dem bisher aufgelaufenen Wert des als kumulatives Zählwerk ausgeführten Speichers hinzugefügt wird. Da bei einem Impulszug mit strömungsgeschwindigkeits- bzw. leistungsproportionaler Frequenz jeder Impuls einem bestimmten Volumen des Fluids bzw. einer bestimmten Energiemenge entspricht, steht daher am Ende jeder Meßperiode am Ausgang des Potenzwertbildners die n-te Potenz des während dieser Meßperiode geflossenen Flüssigkeitsvolumens bzw. der verbrauchten Energiemenge als Zahlenwert zur Verfügung. Durch das kumulative Zählwerk erfolgt die Aufsummierung all dieser Potenzwerte über eine Ableseperiode. Damit wird die in der betrachteten Meßperiode aufgetretene Strömungsgeschwindigkeit bzw. Leistung stärker als linear gewichtet, da n immer größer als 1 ist. Damit liefert

0065132

das erfindungsgemäße Tarifgerät eine Aussage darüber, wie das Fluid oder die elektrische Energie entnommen wurde, wobei Meßperioden mit hoher Entnahme gegenüber der durch einen Durchflußmengenzähler oder einem Energieverbrauchszähler festgestellten Entnahme nunmehr erheblich höher gewichtet werden. Wie stark diese Erhöhung der Wichtung erfolgen soll, kann durch die Wahl von n festgelegt werden. Die Notwendigkeit, kurzzeitige Bedarfsspitzen befriedigen zu können, schlägt sich bei dem Versorgungsunternehmen u.a. in der Höhe der Bereitstellungskosten, beispielsweise im Fall der Elektrizitätsversorgungsunternehmen durch die Kosten für eine erhöhte Kraftwerkskapazität, nieder. Darüber hinaus gehen im Fall von elektrischer Energie auch die Netzverluste ein, die - bei konstanter Spannung - dem Quadrat der Leistung proportional sind. Daher ist der Wert im kumulativen Speicher des Tarifgerätes ein sinnvoll quantifizierter Ausgangswert für die Tarif- und damit Kostenermittlung, da dieser Wert umso größer ist, je höher und je ungleichmäßiger die Arbeitsentnahme erfolgte; denn bei Durchflußmengenmessern oder Energieverbrauchszählern bleibt die Ungleichmäßigkeit des verbrauchten Volumens des Fluids oder der Energie unberücksichtigt. Dividiert man am Ende einer Meßperiode das durch einen Durchflußmengenmesser erhaltene Flüssigkeitsvolumen oder die durch einen Energieverbrauchszähler ermittelte verbrauchte Energie durch die Dauer der Meßperiode, so erhält man den Mittelwert der in dieser Meßperiode angefallenen Strömungsgeschwindigkeit bzw. verbrauchten Leistung. Bei dem erfindungsgemäßen Tarifgerät dagegen erhält man am Ende der Meßperiode durch Division mit der Meßperiodendauer den Mittelwert der n-ten Potenz der Strömungsgeschwindigkeit bzw. des Energieverbrauchs während dieser Meßperiode. Während also bei durch Durchflußmengenzähler oder Energieverbrauchszähler erfaßten Entnahmemengen ein kurzzeitiger Spitzenverbrauch durch anschließende Verbrauchspausen ohne weiteres ausgeglichen werden kann, ist dies bei durch das erfindungsgemäße Tarifgerät erfaßten Verbrauchsmengen eines Fluids oder einer Energie nicht mehr ohne weiteres der Fall.

In einer bevorzugten Ausführungsform ist der Potenzwertbildner als Quadriereinrichtung ausgeführt. Hierbei kann die Quadriereinrichtung als Multiplizierglied ausgeführt sein, dessen beide Multiplikationseingänge mit dem Ausgang des Impulszählers verbunden sind und dessen Ausgang mit dem kumulierenden Zählwerk verbunden ist. Darüber hinaus wird hierbei auch im Fall der elektrischen Energie der dem Quadrat der Leistung proportionale Netzverlust berücksichtigt.

In einer vorteilhaften Ausführungsform ist zumindest der Potenzwertbildner in Form eines Mikrocomputers realisiert. Bei der inzwischen erreichten hohen Verarbeitungsgeschwindigkeit und den hinreichend niedrigen Beschaffungskosten von Mikrocomputern kann damit ein Tarifgerät kostengünstig erstellt werden. Darüber hinaus kann auch - wenn man sich zum Einsatz eines Mikrocomputers entschließt - die Funktion des Impulszählers sowie des kumulierenden Zählwerks und eine gegebenenfalls erforderliche Weiterverarbeitung der im kumulierenden Zählwerk erhaltenen tarifbestimmenden Größe mit nur geringem Mehraufwand durch ein und denselben Mikrocomputer realisiert sein.

Eine besonders aufwandsarme Realisierung eines Tarifgerätes mit handelsüblichen Bausteinen der Digitaltechnik besteht darin, daß die Impulsfolge an den Takteingang eines k-stufigen Rückwärtszählers mit binären Setzeingängen und über ein Verzögerungsglied an den Zähleingang eines als Impulszähler dienenden Vorwärtszählers mit mindestens k-1 Binäreingängen geführt ist, dessen Rückstelleingang mit dem Ausgang des Meßperiodengebers verbunden ist, daß die Ausgangssignale eines Impulsgebers, dessen Frequenz erheblich höher ist als die Maximalfrequenz der Impulsfolge, immer dann und nur dann dem
Rückzähleingang des Rückwärtszählers zugeführt sind,
wenn der Inhalt des Rückwärtszählers größer als Null ist,
daß die am Rückzähleingang des Rückwärtszählers anstehenden Impulse dem kumulierenden Zählwerk zugeführt sind,
daß der binäre Setzeingang niedrigster Wertigkeit immer
mit einem Setzsignal beaufschlagt ist und daß die binären Setzeingänge höherer Wertigkeit jeweils mit einem
der Binärausgänge des Vorwärtszählers nach ansteigender
Wertigkeit verbunden sind.

Dem kumulierenden Zählwerk kann ein Frequenzteiler vorgeschaltet sein. Damit kann ein relativ langsames Zählwerk, beispielsweise in Form eines durch einen Schrittmotor angetriebenen Rollenzählwerks, verwendet werden.

Um eine einwandfreie Ermittlung der tarifbestimmenden
Größe zu gewährleisten, ist es erforderlich, daß das
kumulierende Zählwerk nichtflüchtig ist, d.h. daß der
im kumulierenden Zählwerk vorhandene Wert auch bei Ausfall der Versorgungsspannung erhalten bleibt.

Eine vorteilhafte Weiterbildung der Erfindung besteht
darin, daß der Impulsgeber triggerbar ist und dem Triggereingang ein Einschaltsignal zugeführt ist, das nur
bei einem vom Inhalt Null abweichenden Zustand des Rückwärtszählers ansteht. Damit wird in einfacher Weise erreicht, daß immer dann, wenn der Rückwärtszähler einen
bestimmten, von Null abweichenden Wert aufweist, stets
eine zuverlässige Entleerung bis zum Wert Null stattfindet, wobei die zur Entleerung benötigten Impulse im
kumulierenden Zählwerk aufaddiert werden.

Eine alternative Ausführungsform besteht darin, daß der
Impulsgeber permanent im Betrieb ist und daß sein Ausgangssignal über einen steuerbaren Schalter an den Rückzähleingang des Rückwärtszählers geführt ist, wobei der Schalter immer dann und nur dann geschlossen ist, wenn der Inhalt des Rückwärtszählers von Null abweicht. Damit kann auf einen triggerbaren Impulsgeber verzichtet werden. Trotzdem findet bei jedem von Null abweichenden Inhalt des Rückwärtszählers eine einwandfreie Abwärtszählung bis zur Erreichung des Inhalts Null des Rückwärtszählers statt. Der steuerbare Schalter kann beispielsweise auch als Gate realisiert sein. Die einfachste Form eines derartigen Gates besteht in einem UND-Gatter, dessen einer Eingang an den Ausgang des Impulsgebers und dessen anderer Eingang mit einem Ausgang des Rückwärtszählers verbunden ist, der solange auf H-Pegel liegt, solange der Inhalt des Rückwärtszählers von Null abweicht. Der Ausgang dieses UND-Gatters ist an den Eingang des kumulierenden Zählwerkes anzuschliessen.

In einer vorteilhaften Ausführungsform weist der Rückwärtszähler einen Indikatorausgang auf, dessen Signal nur bei einem von Null abweichenden Inhalt des Rückwärtszählers aktiv ist. Natürlich können auch die Ausgänge der einzelnen binären Gedächtnisstufen des Rückwärtszählers über ein ODER-Gatter mit einer der Anzahl der Gedächtnisstufen entsprechenden Anzahl von Eingängen zusammengeführt sein, so daß das Ausgangssignal des ODER-Gatters bei jedem von Null abweichenden Inhalt des Rückwärtszählers aktiv ist.

Für die eingangsseitige Impulsfolge kann ein Frequenzteiler vorgesehen sein. Damit wird die Frequenz der Impulsfolge reduziert. Somit können Impulszähler und Rückwärtszähler mit relativ niedrigem Fassungsvermögen eingesetzt werden und es kann bei gleichem Fassungsvermögen des Impulszählers und Rückwärtszählers die Meßperiode vergrößert werden.

0065132

Die Erfindung wird im folgenden anhand von Ausführungsbeispielen in den Figuren 1 bis 4 näher erläutert. Dabei
zeigt:

Fig. 1    in Form eines Blockschaltbildes ein erstes Ausführungsbeispiel des Tarifgerätes,

Fig. 2    ebenfalls in Form eines Blockschaltbildes ein
          weiteres Ausführungsbeispiel des Tarifgerätes,
          bei dem nunmehr n = 2 ist und der Potenzwertbildner als Multiplizierglied ausgeführt ist,

Fig. 3    ein drittes Ausführungsbeispiel des Tarifgerätes
          für n = 2 aus einfachen Bausteinen der Digitaltechnik und

Fig. 4    eine Tabelle zur Erläuterung der Wirkungsweise
          des in Fig. 3 dargestellten Ausführungsbeispiels.

In den drei Ausführungsbeispielen sind übereinstimmende
Funktionsblöcke mit den gleichen Bezugszeichen belegt.

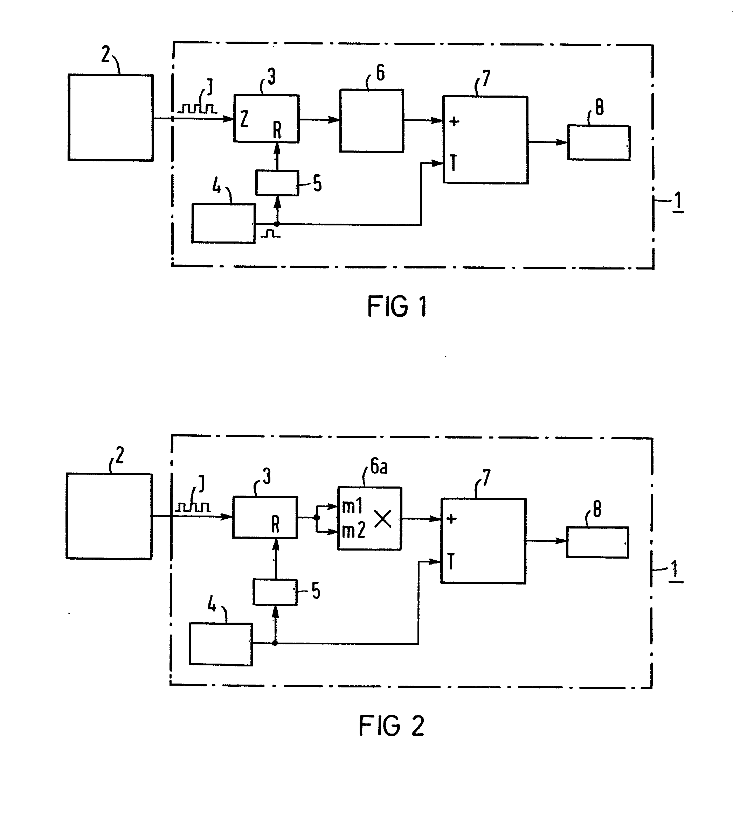

Dem in Fig. 1 dargestellten Tarifgerät 1 wird eingangsseitig eine Impulsfolge I zugeführt, die das Ausgangssignal eines Impulsgeberzählers 2 bildet. Der Impulsgeberzähler 2 ist im Ausführungsbeispiel ein nach dem
Ferraris-Prinzip arbeitender Elektrizitätszähler, bei dem
nach Durchlaufen eines festen Drehwinkels der Läuferscheibe immer einer der Impulse der Impulsfolge I abgegeben
wird. Damit entspricht jeder Impuls dem Verbrauch einer
bestimmten Festmenge elektrischer Energie. Damit ist die
Impulsfolge I so geartet, daß die Frequenz der Einzelimpulse leistungsproportional ist. Anstelle eines solchen
elektromechanischen Elektrizitätszählers 2 kann auch ein
an sich bekannter elektronischer Elektrizitätszähler eingesetzt sein, in dem ebenfalls eine Impulsfolge mit
leistungsproportionaler Frequenz erzeugt und einem kumulierenden Zählwerk zugeführt wird.

Anstelle eines Elektrizitätszählers kann natürlich auch
ein Zähler für andere Energieformen, beispielsweise ein Wärmemengenzähler oder ein Durchflußmengenzähler, eingesetzt sein.

Die Impulsfolge I steht im Tarifgerät 1 am Zähleingang Z eines Impulszählers 3 an. In diesem Impulszähler 3 werden die eingehenden Impulse der Impulsfolge I während jeweils einer durch den Meßperiodengeber 4 vorgegebenen Meßperiode kumuliert. Der Meßperiodengeber 4 kann beispielsweise als monostabile Kippstufe oder als von der Netzfrequenz gespeister Zähler ausgeführt sein. Wesentlich ist, daß der Meßperiodengeber 4 am Ende einer Meßperiode einen Endimpuls liefert, der über eine Verzögerungsstufe 5 dem Rückstelleingang des Impulszählers 3 zugeführt ist.

Der am Ausgang des Impulszählers 3 anstehende Zahlenwert, der der momentanen Zahl der im Impulszähler 3 enthaltenen Impulse entspricht, wird in einem Potenzwertbildner 6 in die $n$-te Potenz erhoben.

Der Endimpuls des Meßperiodengebers 4 steht unverzögert am Triggereingang eines kumulierenden Zählwerkes 7 an, dessen Addiereingang + mit dem Ausgang des Potenzwertbildners 6 verbunden ist. Damit wird am Ende einer jeden Meßperiode der momentan im Potenzwertbildner vorhandene Zahlenwert zu dem bereits im kumulierenden Zählwerk 7 vorhandenen Wert hinzuaddiert. Der so erhaltene Inhalt des kumulierenden Zählwerkes 7, das als nichtflüchtiger Speicher ausgebildet ist, wird auf der Anzeigevorrichtung 8 angezeigt und ist somit am Ende einer Ableseperiode dort ablesbar.

Im Potenzwertbildner 6 wird jeweils die $n$-te Potenz des am Eingang anstehenden Zahlenwertes gebildet, wobei $n > 1$ und vorzugsweise 2 ist. Als Potenzwertbildner 6 können bekannte Rechnerbausteine der Digitaltechnik, wie sie beispielsweise bei Taschenrechnern realisiert sind, ver-

0065132

wendet werden.

Durch die Verzögerungsstufe 5 wird sichergestellt, daß das Zurücksetzen des Impulszählers 3 erst dann erfolgt, wenn der Potenzwert der im Impulszähler 3 während der Meßperiode aufgelaufenen Zahl auch tatsächlich in das kumulierende Zählwerk 7 übernommen ist.

Funktionsblöcke des Tarifgerätes 1 oder auch das gesamte Tarifgerät 1 können durch die Funktionen eines Mikrocomputers realisiert sein.

Das in Fig. 2 dargestellte Ausführungsbeispiel unterscheidet sich von dem in Fig. 1 dargestellten Ausführungsbeispiel lediglich dadurch, daß hier der Potenzwertbildner als Quadriereinrichtung 6a ausgeführt ist, so daß hier $n = 2$ ist. Als Quadriereinrichtung 6a dient hierbei ein digitales Multiplizierglied, dessen beide Multipliziereingänge m1 und m2 mit dem Ausgang des Impulszählers 3 verbunden sind. Ansonsten deckt sich das Blockschaltbild der Fig. 2 mit dem oben erläuterten.

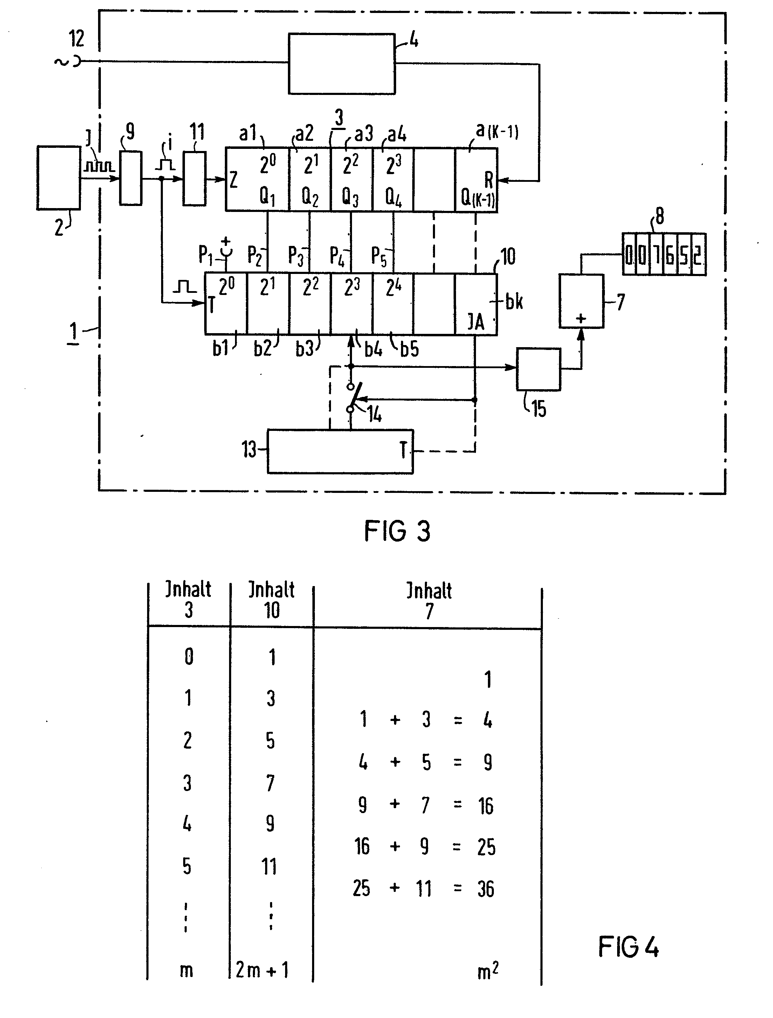

Bei dem in Fig. 3 dargestellten weiteren Ausführungsbeispiel erfolgt mit einfachen Bausteinen der Digitaltechnik eine recht elegante Quadrierung der in den Impulszähler 3 eingehenden Anzahl von Impulsen. Wie in den vorangehenden Ausführungsbeispielen liefert der Impulsgeberzähler 2 ausgangsseitig eine Impulsfolge I, deren Frequenz leistungsproportional (bzw. strömungsgeschwindigkeitsproportional) ist. Diese Impulsfolge I wird im Tarifgerät 1 zunächst einem Frequenzteiler 9 zugeführt. Die niedrigerfrequente Ausgangsimpulsfolge i des Frequenzteiler 9 ist einerseits direkt dem Übernahmetakteingang T eines Rückwärtszählers 10 sowie über eine Verzögerungsstufe 11 dem Zähleingang Z des Impulszählers 3 zugeführt. Der Rückwärtszähler 10 weist k-binäre Gedächtnisstufen b1 bis bk auf, wobei die erste Gedächtnisstufe b1 die Wertigkeit $2^0$, die zweite b2 die Wertigkeit $2^1$ und die k-te die Wertigkeit $2^{(k-1)}$ aufweist. Jede dieser Gedächtnisstufen b1 bis bk ist mit einem Setzeingang $P_1$ bis $P_k$ versehen, wobei die zugehörige Gedächtnisstufe dann gesetzt wird, wenn am Setzeingang H-Pegel ansteht und gleichzeitig am Übernahmetakteingang T ein Impuls eingeht. Darüber hinaus weist der Rückwärtszähler 10 einen Rückzähleingang RZ auf. Geht am Rückzähleingang RZ ein Impuls ein, wird der Inhalt des Rückwärtszählers 10 um eine Einheit erniedrigt. Dies kann solange geschehen, bis der Rückwärtszähler 10 auf den Wert Null zurückgezählt ist. Mit Erreichen des Wertes Null tritt am Indikatorausgang IA ein Signalwechsel auf, also beispielsweise von H-Pegel auf L-Pegel.

Der Impulszähler 3 muß mindestens k - 1 binäre Gedächtnisstufen a1 bis a(k-1) aufweisen, die den Wertigkeiten $2^0$ bis $2^{(k-2)}$ entsprechen. Diesen binären Gedächtnisstufen a1 bis a(k-1) sind entsprechende Binärausgänge $Q_1$ bis $Q_{(k-1)}$ zugeordnet. Darüber hinaus weist der Impulszähler 3 einen Rückstelleingang R auf, über den der Impulszähler 3 auf Null zurückgesetzt werden kann. Der Rückstelleingang R ist im Ausführungsbeispiel mit dem Ausgang des Meßperiodengebers 4 verbunden, an dessen Eingangsklemme 12 eine netzfrequente Wechselspannung ansteht, aus der im Meßperiodengeber 4 Zählimpulse abgeleitet und bis zu einer die Dauer der Meßperiode bestimmenden Obergrenze gezählt werden. Am Ende der vorgebbaren Meßperiode gibt der Meßperiodengeber 4 jeweils einen Endimpuls ab, durch den der Impulszähler 3 auf Null zurückgestellt wird.

Der binäre Setzeingang $P_1$, der der binären Gedächtnisstufe b1 mit der Wertigkeit $2^0$ zugeordnet ist, liegt stets auf H-Pegel. Die Binärausgänge $Q_1$ bis $Q_{(k-1)}$ des Impulszählers 3 sind mit den binären Setzeingängen $P_2$

bis $P_k$ des Rückwärtszählers 10 nach aufsteigenden Wertigkeiten verbunden, also der Binärausgang $Q_1$ mit dem binären Setzeingang $P_2$, der Binärausgang $Q_2$ mit dem binären Setzeingang $P_3$, usw.

Darüber hinaus weist das in Fig. 3 dargestellte Tarifgerät einen Impulsgeber 13 auf, dessen Ausgang über einen steuerbaren Schalter 14 mit dem Rückzähleingang RZ des Rückwärtszählers 10 verbunden ist. Der Steuereingang des steuerbaren Schalters 14 ist an den Indikatorausgang IA des Rückwärtszählers 10 angeschlossen. Der steuerbare Schalter 14 wird hierbei durch das Ausgangssignal des Indikatorausgangs IA geschlossen, solange der Inhalt des Rückwärtszählers 10 von Null abweicht. Der Impulsgeber 10 ist dabei als freischwingender Impulsgeber ausgebildet.

Eine äquivalente Ausführungsform besteht darin, daß der Impulsgeber 13 triggerbar ausgeführt ist und sein Triggereingang T an den Indikatorausgang IA angeschlossen ist. In diesem Fall ist der Ausgang des Impulsgebers 13 ohne Zwischenschaltung eines steuerbaren Schalters 14 direkt an den Rückzähleingang RZ angeschlossen. Dies ist in Fig. 3 gestrichelt dargestellt.

Der Rückzähleingang RZ des Rückwärtszählers 10 ist über einen Frequenzteiler 15 an den Zähleingang + des kumulierenden Zählwerkes 7 angeschlossen, dessen Inhalt auf der Anzeigeeinrichtung 8 ausgegeben wird.

Im folgenden soll die Wirkungsweise dieses Tarifgerätes 1 beschrieben werden. Zu Beginn einer neuen Meßperiode weist der Impulszähler 3 den Inhalt 0 auf, so daß die Binärausgänge $Q_1$ bis $Q_{(k-1)}$ auf L-Pegel liegen. Mit dem Auftreten eines ersten Impulses am Ausgang des Frequenzteilers 9 wird über den Übernahmetakteingang T des Rückwärtszählers 10 das an den binären Setzeingängen $P_1$ bis $P_k$ anstehende Signal übernommen, was dazu führt, daß die erste Gedächtniszelle b1 mit der Wertigkeit $2^0$ gesetzt wird, wohingegen alle anschließenden Gedächtniszellen b2 bis bk ungesetzt bleiben. Damit enthält der Rückwärtszähler 10 nunmehr den Wert 1, so daß durch das Signal am Indikatorausgang IA der steuerbare Schalter 14 geschlossen wird und ein Impuls des Impulsgebers 13 dem Rückzähleingang RZ zugeführt wird. Damit ist wiederum der Wert 0 im Rückwärtszähler 10 erreicht, so daß der steuerbare Schalter wieder geöffnet wird. Dieser oben erwähnte eine Impuls wird dem Frequenzteiler 15 bzw. dem kumulierenden Speicher 7 zugeführt. Die Übernahme des bisherigen Wertes des Impulszählers 3 sowie des am binären Setzeingang P1 anstehenden Signals in den Rückwärtszähler 10 muß am Ende der durch die Verzögerungsstufe 11 gegebenen Zeitspanne abgeschlossen sein, bevor der erste Ausgangsimpuls des Frequenzteilers 9 auch am Zähleingang Z des Impulszählers 3 eingeht und dessen Wert erhöht. Mit Eingehen dieses Impulses am Impulszähler 3 wird die erste Gedächtnisstufe a1 gesetzt, so daß am Binärausgang $Q_1$ nunmehr H-Pegel ansteht, wohingegen an allen folgenden Binärausgängen nach wie vor L-Pegel vorliegt. Erscheint am Ausgang des Frequenzteilers 9 nun ein zweiter Impuls, so bewirkt er über den Übernahmetakteingang T des Rückwärtszählers 10 die Übernahme der an den binären Setzeingängen $P_1$ bis $P_k$ anstehenden Signalpegel. Da nunmehr die binären Setzeingänge $P_1$ und $P_2$ H-Pegel aufweisen, werden nunmehr die beiden binären Gedächtnisstufen b1 und b2 gesetzt, was einem Inhalt des Rückwärtszählers 10 von 3 entspricht. In der anschließenden Zeitspanne vor Auftreten eines dritten Impulses am Ausgang des Frequenzteilers 9 erfolgt nun durch Schließen des steuerbaren Schalters 14 wiederum ein Rückzählen des Rückwärtszählers 10 auf den Wert Null. Hierzu sind drei Impulse des Impulsgebers 13 notwendig, die auch dem Inhalt des Frequenzteilers 15 bzw. des kumulierenden Zählwerkes hinzugefügt werden. Damit steht im kumulierenden Zählwerk 7 nach Auftreten des zweiten Impulses 7 am Ausgang des Frequenzteilers 9 der Wert 4, was dem Quadrat der am Ausgang des Frequenzteilers 9 aufgetretenen und nunmehr auch im Impulszähler 3 eingegangenen Zahl von zwei Impulsen entspricht.

Nach dem verzögerten Eingang des zweiten Impulses in den Impulszähler 3 wird dieser auf den Wert 2 gesetzt, so daß nur der der zweiten Gedächtnisstufe a2 zugeordnete Binärausgang Q2 aktiv wird. Mit Auftreten des dritten Impulses am Ausgang des Frequenzteilers 9 wird damit der Rückwärtszähler 10 auf den Wert 5 gesetzt, worauf durch fünf Impulse des Impulsgebers 13 ein erneutes Zurückzählen des Rückwärtszählers 10 auf den Wert Null eintritt. Diese fünf Impulse werden nun dem im Frequenzteiler 15 bzw. kumulativen Zählwerk 7 vorhandenen Wert von 4 hinzugefügt, so daß nunmehr ein Wert von 9 vorliegt. Dieser Wert 9 entspricht wiederum dem Quadrat der am Ausgang des Frequenzteilers 9 aufgetretenen Impulszahl von 3.

Dadurch, daß der binäre Setzeingang P1 ständig an ein das Setzen der zugehörigen Gedächtnisstufe b1 bewirkendes Potential angeschlossen ist und daß die Binärausgänge des Impulszählers 3 in der beschriebenen Weise mit den binären Setzeingängen $P_1$ bis $P_k$ des Rückwärtszählers 10 verbunden sind, weist im Zeitpunkt unmittelbar nach der durch Eingang eines Ausgangsimpulses des Frequenzteilers 9 am Übernahmetakteingang T des Rückwärtszählers 10 ausgelösten Übernahme des an den Setzeingängen $P_1$ bis $P_k$ anstehenden Signalzustandes (vor Beginn des Rückwärtszählens bis zum Wert Null) der Rückwärtszähler 10 jeweils die Werte auf, die in der mittleren Spalte der Tabelle in Fig. 4 eingetragen sind. Die zugehörigen Inhalte des Impulszählers 3 in diesem Zeitpunkt, da ja der entsprechende Impuls unter der Wirkung der Verzögerungsstufe 4 noch nicht am Zähleingang Z eingegangen ist, sind in der linken Spalte der Tabelle in Fig. 4 eingetragen. Bezeichnet man den aktuellen Inhalt des Impulszählers 3 mit m, so nimmt der Inhalt des Rückwärtszählers 10 in dem erwähnten Zeitpunkt jeweils den Wert 2m+1 an. Der Inhalt des Rückwärtszählers 10 liefert somit alle ungeraden Zahlen in aufsteigender Reihenfolge. Im kumulierenden Zählwerk 7 wird - wie aus der rechten Spalte der Tabelle in Fig. 4 ersichtlich ist - sukzessive die Summe aller ungeraden Zahlen gebildet, was zur Entstehung der Quadratzahlen im kumulierenden Zählwerk 7 Veranlassung gibt. Die Frequenz des Impulsgebers 13 muß noch so hoch sein, daß in der Zeitspanne zwischen der Übernahme der an den Setzeingängen $P_1$ bis $P_k$ anstehenden Signale und dem Eingang des folgenden Impulses des Impulszuges i am Übergabetakteingang T auch bei dem maximalen Inhalt des Rückwärtszählers 10 ein Rückwärtszählen bis zum Stand Null durchführbar ist.

Am Ende einer Meßperiode enthält also das kumulierende Zählwerk 7 die Quadratzahl der vom Frequenzteiler 9 ausgegebenen Impulse. Die Quadrate der entsprechenden Impulszahlen der folgenden Meßperioden werden dem bisherigen Wert im kumulierenden Zählwerk 7 hinzugefügt.

Über die Dauer der Meßperiode kann hierbei festgelegt werden, wie scharf Ungleichmäßigkeiten der Energieentnahme bewertet werden, wobei längere Meßperioden für den Abnehmer günstiger sind. Dies soll anhand eines einfachen Zahlenbeispiels gezeigt werden. In einer Meßperiode von 10 Min. Dauer treten bei konstanter Leistungsentnahme fünf äquidistante Ausgangsimpulse des Frequenzteilers 9 auf. Nach zwei aufeinanderfolgenden Meßperioden von zusammen 20 Min. Dauer ist - vorausgesetzt der Frequenzteiler 15 habe ein Teilungsverhältnis von 1:1 - der Inhalt des kumulierenden Zählwerks 7 um den Wert $5^2+5^2=50$ angestiegen. Erfolgt die Energieentnahme ungleichmäßig, so daß in der ersten Meßperiode 8 Impulse, in der zweiten nur 2 Impulse eingehen, so ist der Wert des kumulierenden

0065132

Zählwerks 7 nach den beiden Meßperioden um 68 angestiegen, obwohl in beiden Fällen die gleiche, dem Wert von 10 Impulsen entsprechende Gesamtenergie entnommen wurde. Verdoppelt man die Dauer einer Meßperiode auf 20 Min., wobei des Untersetzungsverhältnis des Frequenzteilers 9 in gleichem Maß, das heißt auf 2:1 erhöht werden muß, fällt die Ungleichmäßigkeit der Energieentnahme im zweiten Fall nicht mehr ins Gewicht; denn nach sowohl bei gleichmäßiger als auch bei ungleichmäßiger Energieentnahme steigt in diesem Fall der Wert des kumulierenden Zählwerks 7 um den Wert 50. Bei einer Verlängerung der Meßperiode ist es wesentlich, daß das Untersetzungsverhältnis des Frequenzteilers 15 in gleichem Maße verändert wird, so daß bei gleichmäßiger Energieentnahme nach gleichen Zeitspannen ein gleicher Anstieg des Inhalts des kumulierenden Zählwerks 7, unabhängig von der Dauer der Meßperiode, auftritt.

Der am Ende einer Ableseperiode an der Anzeigevorrichtung 8 ablesbare Wert gilt als tarifbestimmende Größe. Er kann beispielsweise mit einem Geldfaktor multipliziert direkt für die Rechnungsstellung von Elektrizitäts-Versorgungsunternehmen verwendet werden.

10 Patentansprüche
4 Figuren

0065132

Patentansprüche

1. Tarifgerät zur Bemessung des einem Abnehmer eines Fluids oder von Energie, insbesondere elektrischer Energie, zuzuordnenden Tarifs, dem eingangsseitig eine Impulsfolge mit strömungsgeschwindigkeits- bzw. leistungsproportionaler Frequenz zugeführt ist, mit mindestens einem Impulszähler für die Impulse der Impulsfolge, mit einem Meßperiodengeber, der jeweils am Ende einer Meßperiode den Impulszähler zurücksetzt, sowie mit einem Speicher mit Anzeigevorrichtung für die tarifbestimmende Größe, d a d u r c h g e k e n n z e i c h n e t , daß der Impulszähler (3) mit einem Potenzwertbildner (6; 10, 11, 13, 14, 7) verbunden ist, der ausgangsseitig die n-te Potenz der während einer Meßperiode im Impulszähler (3) eingegangene Impulszahl liefert, wobei $n > 1$ ist und daß diese n-te Potenz der Impulszahl jeweils am Ende jeder Meßperiode dem bisher aufgelaufenen Wert des als kumulierenden Zählwerk (7) ausgeführten Speichers hinzugefügt wird.

2. Tarifgerät nach Anspruch 1, d a d u r c h g e - k e n n z e i c h n e t , daß der Potenzwertbildner (6) als Quadriereinrichtung ausgeführt ist.

3. Tarifgerät nach Anspruch 2, d a d u r c h g e - k e n n z e i c h n e t , daß die Quadriereinrichtung als Multiplizierglied (6a) ausgeführt ist, dessen beide Multiplikationseingänge (m1, m2) mit dem Ausgang des Impulszählers (3) verbunden sind und dessen Ausgang mit dem kumulierenden Zählwerk (7) verbunden ist.

4. Tarifgerät nach einem der Ansprüche 1 bis 3, d a d u r c h g e k e n n z e i c h n e t , daß zumindest der Potenzwertbildner in Form eines Mikrocomputers realisiert ist.

5. Tarifgerät nach Anspruch 2, d a d u r c h   g e -
k e n n z e i c h n e t , daß die Impulsfolge (I, i) an
den Übernahmetakteingang (T) eines k-stufigen Rückwärtszählers (10) mit binären Setzeingängen ($P_1$ bis $P_k$) und
über ein Verzögerungsglied (11) an den Zähleingang eines
als Impulszähler (3) dienenden Vorwärtszählers mit mindestens k-1 Binärausgängen ($Q_1$ bis $Q_{(k-1)}$) geführt ist,
dessen Rückstelleingang (R) mit dem Ausgang des Meßperiodengebers (4) verbunden ist, daß die Ausgangsimpulse
eines Impulsgebers (13), dessen Frequenz erheblich höher
ist als die Maximalfrequenz der Impulsfolge (I, i), immer
dann und nur dann dem Rückzähleingang (RZ) des Rückwärtszählers (10) zugeführt sind, wenn der Inhalt des Rückwärtszählers (10) größer als Null ist, daß die am Rückzähleingang (RZ) des Rückwärtszählers (10) anstehenden
Impulse dem kumulierenden Zählwerk (7) zugeführt sind,
daß der binäre Setzeingang ($P_1$) niedrigster Wertigkeit
immer mit einem Setzsignal beaufschlagt ist und daß die
binären Setzeingänge ($P_2$ bis $P_k$) höherer Wertigkeit
jeweils mit einem der Binärausgänge ($Q_1$ bis $Q_{(k-1)}$) des
Vorwärtszählers (3) nach ansteigender Wertigkeit verbunden sind.

6. Tarifgerät nach Anspruch 5, d a d u r c h   g e -
k e n n z e i c h n e t , daß dem kumulierenden Zählwerk (7) ein Frequenzteiler (15) vorgeschaltet ist.

7. Tarifgerät nach Anspruch 5 oder 6, d a d u r c h
g e k e n n z e i c h n e t , daß der Impulsgeber (13)
triggerbar ist und dem Triggereingang (T) ein Einschaltsignal zugeführt ist, das nur bei einem vom Inhalt Null
abweichenden Zustand des Rückwärtszählers (10) ansteht.

8. Tarifgerät nach Anspruch 5 oder 6, d a d u r c h
g e k e n n z e i c h n e t , daß der Impulsgeber (13)
permanent in Betrieb ist und daß sein Ausgangssignal
über einen steuerbaren Schalter (14) an den Rückzähleingang (RZ) des Rückwärtszählers (10) geführt ist, wobei der Schalter (14) immer dann und nur dann geschlossen ist, wenn der Inhalt des Rückwärtszählers (10) von Null abweicht.

9. Tarifgerät nach einem der Ansprüche 5 bis 8, **d a - d u r c h   g e k e n n z e i c h n e t**, daß der Rückwärtszähler einen Indikatorausgang (IA) aufweist, dessen Signal nur bei einem von Null abweichenden Inhalt des Rückwärtszählers (10) aktiv ist.

10. Tarifgerät nach einem der Ansprüche 1 bis 9, **d a - d u r c h   g e k e n n z e i c h n e t**, daß für den eingangsseitigen Impulszug (I) ein Frequenzteiler (9) vorgesehen ist.

0065132

FIG 1

FIG 2

FIG 3

| Jnhalt 3 | Jnhalt 10 | Jnhalt 7 | | | | |
|---|---|---|---|---|---|---|
| 0 | 1 | | | | | |
| 1 | 3 | | | | | 1 |
| 2 | 5 | 1 | + | 3 | = | 4 |
| 3 | 7 | 4 | + | 5 | = | 9 |
| 4 | 9 | 9 | + | 7 | = | 16 |
| 5 | 11 | 16 | + | 9 | = | 25 |
| ⋮ | ⋮ | 25 | + | 11 | = | 36 |
| $m$ | $2m+1$ | | | | | $m^2$ |

FIG 4

Europäisches
Patentamt

**EUROPÄISCHER RECHERCHENBERICHT**

0065132

Nummer der Anmeldung

EP 82 10 3522.7

| Kategorie | Kennzeichnung des Dokuments mit Angabe, soweit erforderlich, der maßgeblichen Teile | betrifft Anspruch |
|---|---|---|
| Y | DE - B2 - 2 214 629 (LAUDIS & GYR AG)<br>* Anspruch 1; Spalte 5, Zeile 14 bis Spalte 6, Zeile 18; Fig. 1 * | 1 |
| A | * Spalte 10, Zeile 51 bis Spalte 12, Zeile 46; Fig. 6, 7 * | 2,5 |
| | -- | |
| Y | DE - A1 - 2 730 776 (SIEMENS AG)<br>* Anspruch 1 * | 1 |
| A | | 5 |
| | -- | |
| Y | DE - B2 - 2 729 617 (SIEMENS AG)<br>* Anspruch 1 * | 1 |
| A | | 5 |
| | -- | |
| A | EP - A1 - 0 008 630 (SIEMENS AG)<br>* Seite 1, Zeile 12 bis Seite 2, Zeile 1 * | 4 |
| | ---- | |

**EINSCHLÄGIGE DOKUMENTE**

**KLASSIFIKATION DER ANMELDUNG (Int. Cl.³)**

G 01 R 11/56
G 01 R 21/00
G 01 F 15/075

**RECHERCHIERTE SACHGEBIETE (Int. Cl.³)**

G 05 F 15/075
G 01 R 11/00
G 01 R 21/00

**KATEGORIE DER GENANNTEN DOKUMENTE**

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze
E: älteres Patentdokument, das jedoch erst am oder nach dem Anmeldedatum veröffentlicht worden ist
D: in der Anmeldung angeführtes Dokument
L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Berlin | 30-07-1982 | LEMMERICH |

EPA form 1503.1  06.78